# EUROPÄISCHE PATENTSCHRIFT

(11) **EP 2 969 913 B1**
(45) Veröffentlichungstag und Bekanntmachung des Hinweises auf die Patenterteilung: **10.05.2017**
(21) Anmeldenummer: 14710849.2
(22) Anmeldetag: 12.03.2014
(51) Int. Cl.: B81C 1/00

(54) **HERSTELLUNGSVERFAHREN FÜR EIN MIKROMECHANISCHES BAUELEMENT UND ENTSPRECHENDES MIKROMECHANISCHES BAUELEMENT**
METHOD FOR PRODUCING A MICROMECHANICAL COMPONENT, AND CORRESPONDING MICROMECHANICAL COMPONENT
PROCÉDÉ DE FABRICATION D'UN COMPOSANT MICROMÉCANIQUE ET COMPOSANT MICROMÉCANIQUE CORRESPONDANT

(30) Priorität: 14.03.2013 DE 102013204475
(43) Veröffentlichungstag der Anmeldung: 20.01.2016
(73) Patentinhaber: Robert Bosch GmbH, 70442 Stuttgart (DE)
(72) Erfinder: HEUCK, Friedjof, 70197 Stuttgart (DE); SCHELLING, Christoph, 70597 Stuttgart (DE)
(86) Internationale Anmeldenummer: PCT/EP2014/054876
(87) Internationale Veröffentlichungsnummer: WO 2014/140120

(56) Entgegenhaltungen:
- US-A1- 2002 180 306
- US-A1- 2003 049 878
- US-A1- 2008 188 064
- US-A1- 2009 085 426
- US-A1- 2012 090 057

## Beschreibung

Die vorliegende Erfindung betrifft ein Herstellungsverfahren für ein mikromechanisches Bauelement.

Aus der US 2012/090057 A1 und der US 2008/188064 A1 ist ein Herstellungsverfahren für ein mikromechanisches Bauelement bekannt, bei dem ein Substrat mit einer in Strukturbereiche strukturierten freiliegenden Startschicht bereitgestellt wird, wobei die Strukturbereiche eine Oberseite und laterale Flanken aufweisen, wobei auf der Oberseite eine Katalysatorschicht vorgesehen ist, welche geeignet ist, ein Siliziumwachstum der Oberseite der strukturierten einkristallinen Startschicht zu fördern und wobei auf den Flanken keine Katalysatorschicht vorgesehen ist. Ein selektiver Aufwachsprozess an der Oberseite der freiliegenden Startschicht mittels der Katalysatorschicht wird in einer Reaktivgasatmosphäre zum Ausbilden einer mikromechanischen Funktionsschicht durchgeführt.

Die US 2003/0049878 A1 offenbart ein mikromechanisches Bauelement mit einer in Strukturbereiche strukturierten freiliegenden Startschicht wobei die Strukturbereiche eine Oberseite und laterale Flanken aufweisen, die durch einen selektiven Aufwachsprozess einer mikromechanischen Funktionsschicht herstellbar sind wodurch ein Höhenwachstum und im wesentlichen kein Breitenwachstum der Startschicht erfolgt.

### Stand der Technik

Oberflächen-mikromechanisch hergestellte MEMS-Strukturen mit hohen Aspektverhältnissen werden in der Regel durch Strukturieren von dicken Schichten, beispielsweise Polysiliziumschichten, mittels eines DRIE-Ätzprozesses (trockenes reaktives Ionenätzen) hergestellt. Dieses Vorgehen hat jedoch Besonderheiten für MEMS-Bauelemente mit Strukturelementen, die in der Ebene angetrieben werden und über Federelemente aufgehängt sind. Bedingt durch den Aufbau der DRIE-Ätzanlagen weisen die Strukturen zum Waferrand hin keine symmetrischen Querschnitte mehr auf, sondern sind parallelogrammartig verzerrt. Dies hat zur Folge, dass ein unerwünschtes Bewegungsmoment aus der Ebene heraus entstehen kann, was sich möglicherweise auf die Funktionstüchtigkeit auswirkt.

Beispielsweise verlangt die durch die parallelogrammartige Verzerrung notwendige Korrektur bei Drehratensensoren im MEMS- und ASIC-Design einen hohen Grad an Komplexität und Chipfläche. Dies drückt sich hauptsächlich in der sogenannten Quadraturkompensation aus. Die Quadratur ist ein durch den Antrieb des Drehratensensors in die Detektion eingekoppeltes Fehlersignal. Diese Kompensation erfordert die Bereitstellung von Spannungen größer als 10 V, welche nur mit hohen Kosten verbunden vom ASIC bereitgestellt werden können.

Darüber hinaus bestehen die Funktionsschichten heutzutage in vielen Fällen aus polykristallinen Siliziumschichten. Die Korngrößen sind dabei in der Größenordnung der lateralen Federbreiten, was dazu führt, dass einzelne Körner und deren Kristallorientierung in Bereichen von Stressmaxima das mechanische Verhalten einzelner Federaufhängungen stark beeinflussen können.

Vapor-Liquid-Solid- bzw. Vapor-Solid-Solid-Verfahren zum selektiven Wachstum von einkristallinen Schichten sind beispielsweise bekannt aus "Growth, Thermodynamics, and Electrical Properties of Silicon Nanowires", V. Schmidt, J.V. Wittemann und U. Gösele in Chem. Ref. 2010, 110, Seiten 361 bis 388 sowie aus "Catalytic Growth of Nanowires: Vapor-Liquid-Solid, Vapor-Solid-Solid, Solution-Liquid-Solid and Solid-Liquid-Solid Growth", K.W. Kolasinski, Current Opinion in Solid State and Materials Science 10 (2006), Seiten 182 bis 191.

### Offenbarung der Erfindung

Die vorliegende Erfindung schafft ein Herstellungsverfahren für ein mikromechanisches Bauelement nach Anspruch 1.

Bevorzugte Weiterbildungen sind Gegenstand der Unteransprüche.

### Vorteile der Erfindung

Die der vorliegenden Erfindung zugrunde liegende Idee besteht darin, anstatt subtraktiv Material einer zuvor ganzflächig abgeschiedenen mikromechanischen Funktionsschicht in einem DRIE-Schritt zu entfernen, das Material in einer Vorstufe als Startschicht zu strukturieren und anschließend additiv kristallin und selektiv durch eine Katalysatorschicht gesteuert aufzuwachsen. Die vorliegende Erfindung ermöglicht es somit, selektiv einkristalline MEMS-Strukturen mit symmetrischen Querschnitten über einen gesamten Wafer herzustellen.

Insbesondere sind durch das erfindungsgemäße Verfahren symmetrische Profilquerschnitte für mikromechanische Federn in Inertialsensoren herstellbar.
Für Drehratensensoren führt bereits eine Asymmetrie von 0,5° in den Flankenwinkeln der Aufhängefedern zu einer unerwünschten Modenanregung. Durch die Sicherstellung einer auf weniger als beispielsweise 0,5° - idealerweise auf weniger von 0,1° - von der niedrigindizierten Kristallebene fehlorientierten Startschicht kann die störende Modenanregung für bestimmte Sensoren signifikant verbessert werden.

Dies hat eine Reduktion der Quadratur zur Folge, wodurch ein kleinerer und damit kostengünstigerer ASIC aufgrund des Entfalls der Hochvoltoption in der Schaltung einsetzbar ist. Höhere Aspektverhältnisse sowohl in den Strukturen als auch in den Abständen sind durch das erfindungsgemäße Verfahren im Vergleich zu bekannten subtraktiven DRIE-Verfahren erreichbar. Auch sind geringere Spaltabstände für mikromechanische Detektionselektroden realisierbar. Aufgrund der Abscheidung von einkristallinen Strukturen bilden sich keine Korngrenzen aus, was eine stark eingeschränkte E-Modul-Streuung der betreffenden mikromechanischen Strukturen zur Folge hat. Das erfindungsgemäße Verfahren ermöglicht zudem eine Abscheidung in einem Batch-Prozess im Gegensatz zur bekannten Einzelwafer-DRIE-Strukturierung.

Auch ergibt sich ein potenzieller Kostenvorteil durch die Strukturierung einer dünnen einkristallinen Startschicht und anschließendes selektives Aufwachsen gegenüber den bekannten Verfahren, welche auf einem Abscheiden einer dicken Funktionsschicht und einem anschließenden Strukturieren derselben mit DRIE beruhen.

Gemäß einer bevorzugten Ausführungsform besteht die Startschicht aus einkristallinem Material, insbesondere Silizium. Dies hat den Vorteil, dass die Siliziumtechnologie gut beherrscht und ausgereift ist.

Gemäß einer weiteren bevorzugten Ausführungsform weist die Oberseite eine Verkippung von weniger als 0,5° gegenüber einer niedrig indizierten Kristallebene, insbesondere der (111)-Ebene auf. Dies hat sich für bestimmte Sensoranwendungen als besonders günstig herausgestellt.

Gemäß einer weiteren bevorzugten Ausführungsform verlaufen die Oberseiten im Wesentlichen eben und die Flanken im wesentlichen vertikal zur Oberseite. Dies ist eine für viele Anwendungen vorteilhafte Geometrie.

Gemäß einer weiteren bevorzugten Ausführungsform werden die Startschicht und die Katalysatorschicht zunächst unstrukturiert aufeinander vorgesehen und anschließend durch einen Ätzprozess gemeinsam strukturiert. Dadurch läßt sich eine geringe Anzahl von Prozessschritten erreichen.

Gemäß einer weiteren bevorzugten Ausführungsform wird die Startschicht zunächst ohne die Katalysatorschicht strukturiert und anschließend die Katalysatorschicht auf der Oberseite gebildet und strukturiert. Auch diese Alternative ist sehr kostengünstig darstellbar.

Gemäß einer weiteren bevorzugten Ausführungsform werden an den Flanken Spacer vor dem Durchführen des selektiven Aufwachsprozesses gebildet. Die Spacer sorgen für eine strukturtreue Abbildung beim späteren Aufwachsprozess, denn sie verhindern beispielsweise ein Zusammenziehen einer Flüssigphase durch Kapillareffekte in konvexen Ecken.

Gemäß einer weiteren bevorzugten Ausführungsform wird die Katalysatorschicht aus einem der Elemente 4. bis 15. Hauptgruppe des Periodensystems gebildet. Diese Elemente eignen sich sehr gut für das VLS- bzw. VSS-Wachstum.

Gemäß einer weiteren bevorzugten Ausführungsform werden an den Flanken Spacer vor dem Bilden der Katalysatorschicht gebildet, daran anschließend die Katalysatorschicht abgeschieden, wobei die Katalysatorschicht mit der Oberseite reagiert und nicht mit den Spacern reagiert, und der nicht reagierte Teil der Katalysatorschicht schließlich selektiv von den Spacern entfernt wird. Dadurch können die Spacer eine Doppelfunktion erfüllen.

Gemäß einer weiteren bevorzugten Ausführungsform wird beim Durchführen des selektiven Aufwachsprozesses eine silanhaltige Gasatmosphäre, insbesondere bei einer Temperatur von mehr als 600 °C, verwendet. Hierdurch läßt sich ein besonderes effektives Wachstum erzielen.

Gemäß einer weiteren bevorzugten Ausführungsform wird die Katalysatorschicht nach dem Durchführen des selektiven Aufwachsprozesses entfernt wird. Dies kann zweckmäßig sein, wenn weitere Funktionselemente in darüberliegenden Ebenen zu bilden sind.

### Kurze Beschreibung der Zeichnungen

Die vorliegende Erfindung wird nachfolgend anhand der in den schematischen Figuren der Zeichnungen angegebenen Ausführungsbeispiele näher erläutert. Es zeigen:
- Fig. 1a) - f): schematische Querschnittsdarstellungen zur Erläuterung eines mikromechanischen Bauelements und eines entsprechenden Herstellungsverfahrens gemäß einer ersten Ausführungsform der vorliegenden Erfindung; und
- Fig. 2a)-f): schematische Querschnittsdarstellungen zur Erläuterung eines mikromechanischen Bauelements und eines entsprechenden Herstellungsverfahrens gemäß einer zweiten Ausführungsform der vorliegenden Erfindung.

### Ausführungsformen der Erfindung

In den Figuren bezeichnen gleiche Bezugszeichen gleiche bzw. funktionsgleiche Elemente.

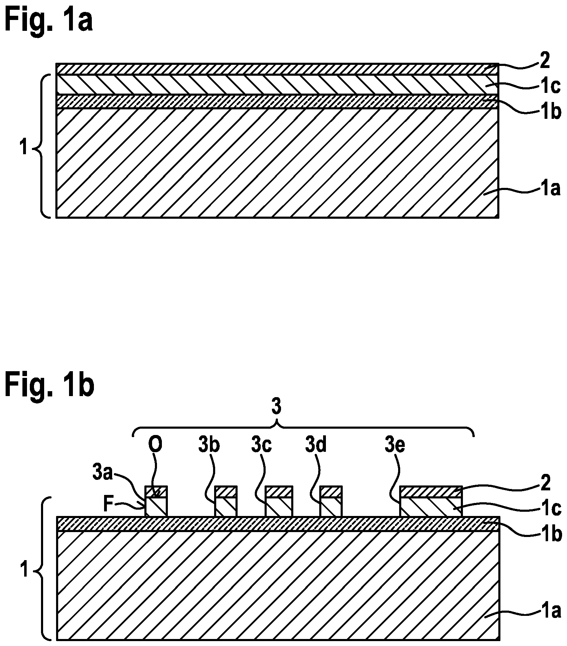

Fig. 1a)-f) zeigen schematische Querschnittsdarstellungen zur Erläuterung eines mikromechanischen Bauelements und eines entsprechenden Herstellungsverfahrens gemäß einer ersten Ausführungsform der vorliegenden Erfindung.

In Fig. 1a) bis e) bezeichnet Bezugszeichen 1 ein SOI-Substrat mit einer ersten Siliziumschicht 1a, einer auf der ersten Siliziumschicht 1a befindlichen Oxidschicht 1 b, und einer auf der Oxidschicht 1 b befindlichen zweiten einkristallinen Siliziumschicht 1 c.

Die einkristalline Siliziumschicht 1c ist beim vorliegenden Beispiel als eine (111)-Kristallebene ausgebildet. Gemäß Fig. 1a) wird auf der einkristallinen Siliziumschicht 1 c eine Katalysatorschicht 2 ausgebildet, welche beispielsweise Zn, Ag, Al, Cu, Au, Ni oder Pt aufweist.

Für das VLS (Vapor-Liquid-Solid)- bzw. VSS (Vapor-Solid-Solid)-Wachstum von Silizium kommen bekannterweise prinzipiell zahlreiche metallische Elemente des Periodensystems als Katalysatoren in Frage.

Einige dieser Katalysatoren bilden dabei ein festes oder flüssiges Silizid, andere ein Silizium-Eutektikum aus. Die Katalysatoren besitzen idealerweise folgende Eigenschaften. Erstens fördern sie eine hohe Wachstumsrate durch ihre hohe Löslichkeit für Silizium bzw. durch ihre niedrige Aktivierungsenergie für das Wachstum. Zweitens sind sie idealerweise kompatibel mit CMOS-Prozessen, sodass die Prozessierung in bekannter Halbleitertechnologie erfolgen kann. Drittens besitzen sie einen niedrigen Dampfdruck, sodass der Katalysator nicht während des Wachstums verdampft. Gerade die Verwendung von festen Siliziden verspricht eine hohe Strukturtreue, da damit Strukturen unabhängig von Oberflächenspannungen der flüssigen Silizide entworfen und hergestellt werden können.

Aufgrund dieser angegebenen Anforderungen sind insbesondere, aber nicht ausschließlich, die oben angegebenen Metalle Zn, Ag, Al, Cu, Au, Ni und Pt zur Bildung der Katalysatorschicht 2 interessant, allerdings ist die Erfindung darauf nicht beschränkt, sondern es können prinzipiell alle Elemente der 4. bis 15. Hauptgruppe des Periodensystems dafür verwendet werden.

Beim Abscheiden der Katalysatorschicht 2 auf der einkristallinen Siliziumschicht 1 c reagiert das Katalysatormetall mit dem darunter befindlichen Silizium, also beispielsweise zur Bildung eines entsprechenden Silizids.

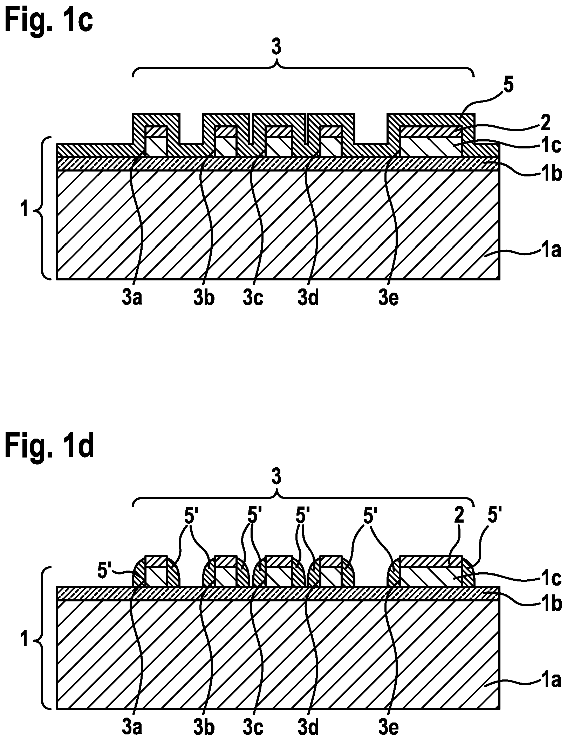

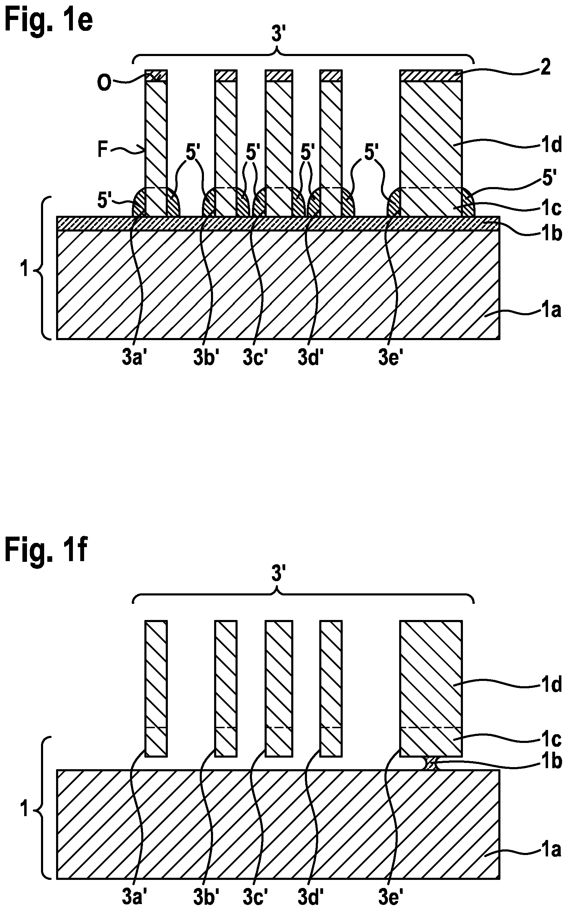

In einem darauffolgenden Prozessschritt, welcher in Fig. 1 b) illustriert ist, erfolgt ein Schritt des gemeinsamen Strukturierens der Katalysatorschicht 2 und der darunter befindlichen einkristallinen Siliziumschicht in Strukturbereiche 3a bis 3e, wobei letztere somit eine Startschicht mit einer Vorläuferstruktur 3 einer später daraus durch selektives additives Wachstum zu bildenden mikromechanischen Funktionsschicht 3' (vgl. Fig. 1e)) bildet. Das Strukturieren erfolgt vorzugsweise mittels eines Ätzprozesses, welcher auf der Oxidschicht 1 b stoppt.

Wie aus Fig. 1b) ersichtlich, ist nach dem Ätzschritt eine Oberseite O der strukturierten einkristallinen Siliziumschicht 1c mit der Katalysatorschicht 2 bedeckt, wohingegen die Flanken F der Strukturbereiche 3a bis 3e der strukturierten einkristallinen Polysiliziumschicht 1c davon unbedeckt sind.

Weiter mit Bezug auf Fig. 1c) wird über der strukturierten einkristallinen Polysiliziumschicht 1c mit der an der Oberseite O befindlichen Katalysatorschicht 2 eine weitere Oxidschicht 5 abgeschieden.

In einem anschließenden Prozessschritt, welcher in Fig. 1d) illustriert ist, erfolgt ein trockenes Rückätzen der Oxidschicht 5 durch einen Trockenätzprozess, wodurch Spacer 5' aus Oxid an den Flanken der Strukturbereiche 3a bis 3e entstehen.

Die Oxidspacer 5' sorgen für eine strukturtreue Abbildung beim späteren Aufwachsprozess, denn sie verhindern beispielsweise ein Zusammenziehen einer Flüssigphase durch Kapillareffekte in konvexen Ecken. Allerdings können sie unter Umständen in Abhängigkeit vom verwendeten Abscheidungsprozess und Material auch weggelassen werden.

Danach mit Bezug auf Fig. 1e) erfolgt ein selektiver Aufwachsprozess an der Oberseite O der Strukturbereiche 3a bis 3e der strukturierten einkristallinen Siliziumschicht 1 c mittels der Katalysatorschicht 2 in einer Reaktivgasatmosphäre, wodurch ein Höhenwachstum und im Wesentlichen kein Breitenwachstum der Strukturbereiche 3a bis 3e erfolgt. Dadurch wird eine mikromechanische Funktionsschicht 3' mit Strukturbereichen 3a' bis 3e' aus einkristallinem Silizium auf der Oxidschicht 1 b und unter der Katalysatorschicht 2 ausgebildet.

Beim Durchführen des selektiven Aufwachsprozesses wird vorzugsweise eine silanhaltige Gasatmosphäre (z. B. mit Dichlorsilan) bei einer Temperatur von mehr als 600 °C verwendet. Die Tatsache, dass sich an den Flanken F kein Siliziumwachstum einstellt, liegt daran, dass sich an den Flanken F ein thermodynamisches Gleichgewicht zwischen einem Abscheidungsprozess und einem Ätzprozess ausbildet.

Das VLS- bzw. VSS-Wachstum von Strukturflanken erfolgt völlig symmetrisch zu den Kristallebenen. Die Oberfläche und damit die Flanken der mit den VLS- bzw. VSS-Verfahren aufgewachsenen Strukturen orientieren sich nämlich an thermodynamisch günstigen Kristalloberflächen. Die Fehlorientierung zwischen den beiden Flankenwinkeln von mit dem VLS- bzw. VSS-Verfahren gewachsenen Strukturen ist deswegen in guter Näherung direkt durch die Fehlorientierung der Startschicht in Form der einkristallinen Siliziumschicht 1c gegeben.

Schließlich mit Bezug auf Fig. 1f) erfolgt ein Opferschichtätzen, beispielsweise mittels HF-Gasphasenätzen, um die Oxidschicht 1 b, welche als Opferschicht dient, bereichsweise zu entfernen, so dass die Strukturbereiche 3a', 3b', 3c' und 3d' über der ersten Siliziumschicht 1 a beweglich gemacht werden, wohingegen der Strukturbereich 3e' über einem verbleibenden Teil der Oxidschicht 1 b mit der ersten Siliziumschicht 1a als Verankerung verbunden bleibt. Eine derart ausgebildete mikromechanische Funktionsschicht 3' ist beispielsweise eine verankerte Federstruktur als Bestandteil eines Inertialsensors, insbesondere eines Drehratensensors.

Hinsichtlich der Katalysatorschicht 2 sei erwähnt, dass diese, wie im vorliegenden Ausführungsbeispiel gezeigt, optional mittels Ionenstrahlätzen oder Plasmaätzen entfernt werden kann. Allerdings kann es auch Anwendungen geben, bei denen die Katalysatorschicht 2 auf der mikromechanischen Funktionsschicht 3' belassen werden kann.

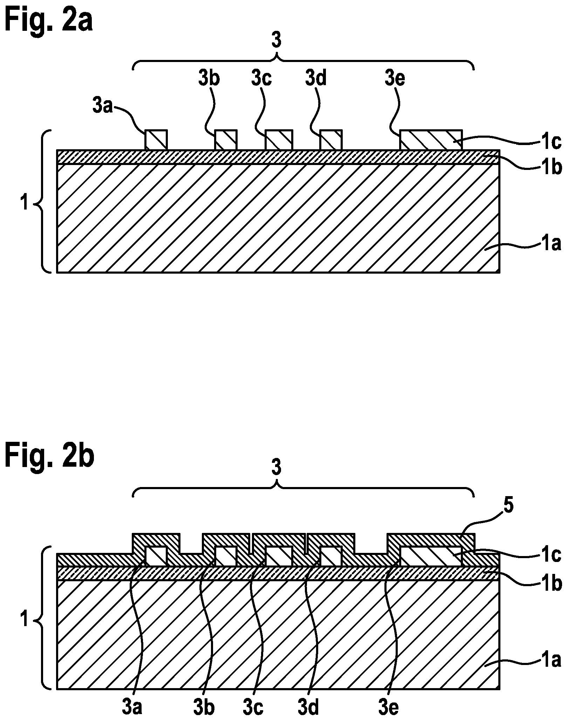

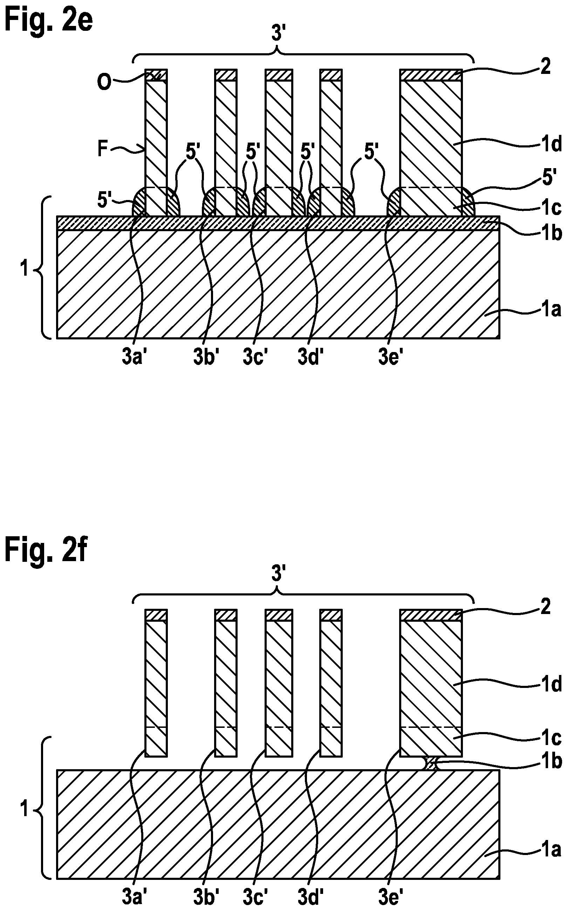

Fig. 2a)-f) zeigen schematische Querschnittsdarstellungen zur Erläuterung eines mikromechanischen Bauelements und eines entsprechenden Herstellungsverfahrens gemäß einer zweiten Ausführungsform der vorliegenden Erfindung.

Bei der zweiten Ausführungsform wird im Unterschied zur ersten Ausführungsform zunächst die einkristalline Siliziumschicht 1c in einem Ätzprozess in die Strukturbereiche 3a bis 3e der Vorläuferstruktur 3 ohne darauf befindliche Katalysatorschicht 2 strukturiert, wie in Fig. 2a) gezeigt.

Anschließend wird mit Bezug auf Fig. 2b) eine weitere Oxidschicht 5 über der in die Strukturbereiche 3a bis 3e strukturierten einkristallinen Siliziumschicht 1 c abgeschieden.

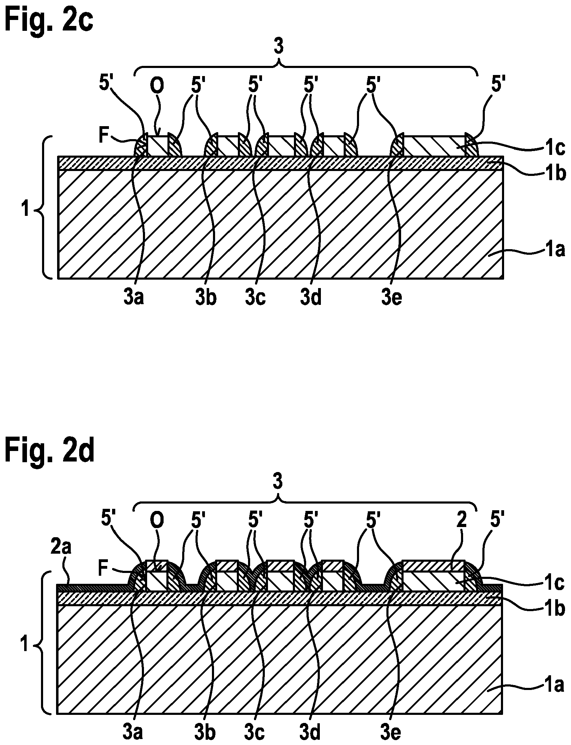

Durch ein gerichtetes Rückätzen der Oxidschicht 5 lassen sich Spacer 5' aus Oxid an den Flanken F der Strukturbereiche 3a bis 3e erzeugen, wohingegen die Oberseite O davon unbedeckt bleibt, wie in Fig. 2c) gezeigt.

Wie weiter mit Bezug auf Fig. 2d) wird anschließend die Katalysatorschicht 2 über der strukturierten einkristallinen Siliziumschicht 1c mit den Spacern 5' durch Abscheidung des Katalysatormetalls bei einer entsprechenden Temperatur gebildet, wobei die Katalysatorschicht 2 mit der freiliegenden Oberseite O reagiert, aber nicht mit den Spacern 5' aus Oxid bzw. der Oxidschicht 1 b. So lässt sich in einem nicht dargestellten weiteren Prozessschritt der nicht reagierte Teil der Katalysatorschicht selektiv von den Spacern 5' und der Oxidschicht 1 b entfernen, was zu einem Prozesszustand analog Fig. 1b) führt.

Wie in Fig. 2e) dargestellt, erfolgt dann in Analogie zur ersten Ausführungsform der selektive Aufwachsprozess, um aus der einkristallinen Siliziumschicht 1 c mit den Strukturbereichen 3a bis 3e die mikromechanische Funktionsschicht 3' zu bilden.

Beim vorliegenden Ausführungsbeispiel findet ebenfalls ein Opferschichtätzen in Analogie zum obigen ersten Ausführungsbeispiel statt, jedoch verbleibt die Katalysatorschicht 2 auf der mikromechanischen Funktionsschicht 3'. Die Katalysatorschicht 2 kann somit entweder zur Reduzierung des elektrischen Widerstandes und/oder als eutektische Bondmetallschicht für eine Sensorkappe auf der mikromechanischen Funktionsschicht 3' verwendet werden.

Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar.

Insbesondere sind die angegebenen Materialien und Strukturen nur beispielhaft und nicht einschränkend angegeben.

Das erfindungsgemäße Verfahren eignet sich, wie gesagt, insbesondere zur Darstellung von im Querschnitt symmetrischen Strukturen, insbesondere Federstrukturen, in MEMS-Bauelementen mit einer Asymmetrie von weniger als 0,5°. Derartige Strukturen finden insbesondere Verwendung bei Verfahren zum Herstellen von Inertialsensoren, insbesondere Drehratensensoren. Allerdings ist es generell auf beliebige mikromechanische Funktionsstrukturen anwendbar.

## Patentansprüche

1. Herstellungsverfahren für ein mikromechanisches Bauelement mit den Schritten:
Bereitstellen eines Substrats (1) mit einer ersten Siliziumschicht (1a), einer auf der ersten Siliziumschicht (1a) befindlichen Oxidschicht (1 b) und einer auf der Oxidschicht (1 b) befindlichen, in Strukturbereiche (3a-3e) strukturierten freiliegenden Startschicht (1c), wobei die Strukturbereiche (3a-3e) eine Oberseite (O) und laterale Flanken (F) aufweisen, wobei auf der Oberseite (O) eine Katalysatorschicht (2) vorgesehen ist, welche geeignet ist, ein Siliziumwachstum der Oberseite (O) der strukturierten einkristallinen Startschicht (1c) zu fördern, und wobei auf den Flanken (F) keine Katalysatorschicht (2) vorgesehen ist;
Durchführen eines selektiven Aufwachsprozesses an der Oberseite (O) der freiliegenden Startschicht (1c) mittels der Katalysatorschicht (2) in einer Reaktivgasatmosphäre zum Ausbilden einer mikromechanischen Funktionsschicht (3'); und
Durchführen eines Opferätzschitts zum bereichsweiten Entfernen der Oxidschicht (1 b), um einen Teil der Strukturbereiche (3a' - 3d') beweglich zu machen.

2. Herstellungsverfahren nach Anspruch 1, wobei die Startschicht (1c) einkristallin ist und vorzugszweise aus einkristallinem Silizium besteht.

3. Herstellungsverfahren nach Anspruch 1 oder 2, wobei die Oberseite (O) eine Verkippung von weniger als 0,5° gegenüber einer niedrig indizierten Kristallebene, insbesondere der (111)-Ebene aufweist.

4. Herstellungsverfahren nach einem der vorhergehenden Ansprüche, wobei die Oberseite (O) im wesentlichen eben und die Flanken (F) im wesentlichen vertikal zur Oberseite (O) verlaufen.

5. Herstellungsverfahren nach einem der vorhergehenden Ansprüche, wobei die Startschicht (1c) und die Katalysatorschicht (2) zunächst unstrukturiert aufeinander vorgesehen werden und anschließend durch einen Ätzprozess gemeinsam strukturiert werden.

6. Herstellungsverfahren nach einem der Ansprüche 1 bis 4, wobei die Startschicht (1 c) zunächst ohne die Katalysatorschicht (2) strukturiert wird und anschließend die Katalysatorschicht (2) auf der Oberseite (O) gebildet und strukturiert wird.

7. Herstellungsverfahren nach einem der vorhergehenden Ansprüche, wobei an den Flanken (F) Spacer (5') vor dem Durchführen des selektiven Aufwachsprozesses gebildet werden.

8. Herstellungsverfahren nach einem der vorhergehenden Ansprüche, wobei die Katalysatorschicht (2) aus einem der Elemente 4. bis 15. Hauptgruppe des Periodensystems gebildet wird.

9. Herstellungsverfahren nach Anspruch 6, wobei an den Flanken (F) Spacer (5') vor dem Bilden der Katalysatorschicht (2) gebildet werden, daran anschließend die Katalysatorschicht (2) abgeschieden, wobei die Katalysatorschicht (2) mit der Oberseite (O) reagiert und nicht mit den Spacern (5') reagiert, und der nicht reagierte Teil der Katalysatorschicht (2) schließlich selektiv von den Spacern (5') entfernt wird.

10. Verfahren nach einem der vorhergehenden Ansprüche, wobei beim Durchführen des selektiven Aufwachsprozesses eine silanhaltige Gasatmosphäre, insbesondere bei einer Temperatur von mehr als 600 °C, verwendet wird.

11. Verfahren nach einem der vorhergehenden Ansprüche, wobei die Katalysatorschicht (2) nach dem Durchführen des selektiven Aufwachsprozesses entfernt wird.

## Claims

1. Production method for a micromechanical component having the following steps:
providing a substrate (1) having a first silicon layer (1a), an oxide layer (1b) located on the first silicon layer (1a) and a starting layer (1c), which is located on the oxide layer (1b) and structured and exposed in structure regions (3a-3e), wherein the structure regions (3a-3e) have an upper side (0) and lateral flanks (F), wherein a catalyst layer (2) is provided on the upper side (0), which is suitable for promoting silicon growth of the upper side (0) of the structured monocrystalline starting layer (1c), and wherein no catalyst layer (2) is provided on the flanks (F); performing a selective growth process on the upper side (0) of the exposed starting layer (1c) by means of the catalyst layer (2) in a reactive gas atmosphere to form a micromechanical functional layer (3'); and
perfoming a sacrificial etching step for the regionwide removal of the oxide layer (1b), in order to make a part of the structure regions (3a'-3d') movable.

2. Production method according to Claim 1, wherein the starting layer (1c) is monocrystalline and preferably consists of monocrystalline silicon.

3. Production method according to Claim 1 or 2, wherein the upper side (0) has a tilt of less than 0.5° in relation to a low-index crystal plane, in particular the (111) plane.

4. Production method according to any one of the preceding claims, wherein the upper side (0) extends substantially flatly and the flanks (F) extend substantially vertically in relation to the upper side (O).

5. Production method according to any one of the preceding claims, wherein the starting layer (1c) and the catalyst layer (2) are firstly provided unstructured one on top of another and are subsequently jointly structured by an etching process.

6. Production method according to any one of Claims 1 to 4, wherein the starting layer (1c) is firstly structured without the catalyst layer (2) and subsequently the catalyst layer (2) is formed on the upper side (0) and structured.

7. Production method according to any one of the preceding claims, wherein spacers (5') are formed on the flanks (F) before the performance of the selective growth process.

8. Production method according to any one of the preceding claims, wherein the catalyst layer (2) is formed from one of the elements of the 4th to 15th main groups of the periodic system.

9. Production method according to Claim 6, wherein spacers (5') are formed on the flanks (F) before the formation of the catalyst layer (2), and the catalyst layer (2) is subsequently deposited thereon, wherein the catalyst layer (2) reacts with the upper side (0) and does not react with the spacers (5'), and the unreacted part of the catalyst layer (2) is finally selectively removed from the spacers (5').

10. Method according to any one of the preceding claims, wherein a silane-containing gas atmosphere is used during the performance of the selective growth process, in particular at a temperature of greater than 600°C.

11. Method according to any one of the preceding claims, wherein the catalyst layer (2) is removed after the performance of the selective growth process.

## Revendications

1. Procédé de fabrication d'un composant micromécanique, comprenant les étapes suivantes:
préparer un substrat (1) avec une première couche de silicium (1a), une couche d'oxyde (1b) se trouvant sur la première couche de silicium (1a) et une couche de démarrage libre (1c) structurée en zones de structure (3a-3e) se trouvant sur la couche d'oxyde (1b), dans lequel les zones de structure (3a-3e) présentent un côté supérieur (0) et des flancs latéraux (F), dans lequel il est prévu sur le côté supérieur (0) une couche de catalyseur (2), qui convient pour favoriser une croissance du silicium du côté supérieur (0) de la couche de démarrage monocristalline structurée (1c), et dans lequel il n'est pas prévu de couche de catalyseur (2) sur les flancs (F);
exécuter un processus de croissance sélectif sur le côté supérieur (0) de la couche de démarrage libre (1c) au moyen de la couche de catalyseur (2) dans une atmosphère de gaz réactif pour former une couche fonctionnelle micromécanique (3'); et
exécuter une étape d'attaque sacrificielle pour l'enlèvement localisé de la couche d'oxyde (1b) afin de rendre mobile une partie des zones de structure (3a'-3d').

2. Procédé de fabrication selon la revendication 1, dans lequel la couche de démarrage (1c) est monocristalline et se compose de préférence de silicium monocristallin.

3. Procédé de fabrication selon la revendication 1 ou 2, dans lequel le côté supérieur (0) présente une inclinaison de moins de 0,5° par rapport à un plan cristallin à faible indice, en particulier le plan (111).

4. Procédé de fabrication selon l'une quelconque des revendications précédentes, dans lequel le côté supérieur (0) est essentiellement plan et les flancs (F) sont essentiellement verticaux par rapport au côté supérieur (O).

5. Procédé de fabrication selon l'une quelconque des revendications précédentes, dans lequel la couche de démarrage (1c) et la couche de catalyseur (2) sont d'abord prévues l'une sur l'autre sans structure et sont ensuite structurées en commun par un processus d'attaque.

6. Procédé de fabrication selon l'une quelconque des revendications 1 à 4, dans lequel la couche de démarrage (1c) est d'abord structurée sans la couche de catalyseur (2) et la couche de catalyseur (2) est ensuite formée et structurée sur le côté supérieur (O).

7. Procédé de fabrication selon l'une quelconque des revendications précédentes, dans lequel des écarteurs (5') sont formés sur les flancs (F) avant l'exécution du processus de croissance sélectif.

8. Procédé de fabrication selon l'une quelconque des revendications précédentes, dans lequel la couche de catalyseur (2) est formée d'un des éléments 4 à 15 du groupe principal du système périodique.

9. Procédé de fabrication selon la revendication 6, dans lequel on forme des écarteurs (5') sur les flancs (F) avant la formation de la couche de catalyseur (2), puis on dépose sur ceux-ci la couche de catalyseur (2), dans lequel la couche de catalyseur (2) réagit avec le côté supérieur (0) et ne réagit pas avec les écarteurs (5'), et on enlève finalement de façon sélective des écarteurs (5') la partie de la couche de catalyseur (2) qui n'a pas réagi.

10. Procédé de fabrication selon l'une quelconque des revendications précédentes, dans lequel on utilise une atmosphère gazeuse contenant du silane, en particulier à une température de plus de 600°C, lors de l'exécution du processus de croissance sélectif.

11. Procédé de fabrication selon l'une quelconque des revendications précédentes, dans lequel on enlève la couche de catalyseur (2) après l'exécution du processus de croissance sélectif.
